Europäisches Patentamt

European Patent Office

Office européen des brevets

(19)

(11) **EP 1 521 314 A1**

(12) **EUROPEAN PATENT APPLICATION**
published in accordance with Art. 158(3) EPC

(43) Date of publication:
**06.04.2005 Bulletin 2005/14**

(51) Int Cl.⁷: **H01L 35/14**

(21) Application number: **03736154.0**

(22) Date of filing: **11.06.2003**

(86) International application number:
**PCT/JP2003/007395**

(87) International publication number:
**WO 2004/001864 (31.12.2003 Gazette 2004/01)**

(84) Designated Contracting States:
**AT BE BG CH CY CZ DE DK EE ES FI FR GB GR
HU IE IT LI LU MC NL PT RO SE SI SK TR**

(30) Priority: **19.06.2002 JP 2002177979
01.07.2002 JP 2002192246**

(71) Applicant: **JFE Steel Corporation
Tokyo, 100-0011 (JP)**

(72) Inventor: **Takagi, Katsuhiko,
c/o Intel. Property Dept,
Chiyoda-ku, Tokyo 100-0011 (JP)**

(74) Representative: **Stebbing, Timothy Charles
Haseltine Lake & Co.,
Imperial House,
15-19 Kingsway
London WC2B 6UD (GB)**

(54) **BETA-IRON DISILICATE THERMOELECTRIC TRANSDUCING MATERIAL AND THERMOELECTRIC TRANSDUCER**

(57) The invention aims to provide a thermoelectric conversion material of β-iron disilicides that performs β-phase transformation in as a short time as just the industrially useful level. Moreover, the invention aims to provide a thermoelectric conversion material of β-iron disilicides having a low heat conductivity and a high thermoelectric conversion efficiency without changing Seebeck coefficient and resistivity, and a thermoelectric conversion element using the material. Specifically, a thermoelectric conversion material of β-iron disilicides containing dopant and at least one selected from at least Sn and Pb and a thermoelectric conversion element using the material are provided.

EP 1 521 314 A1

**Description**

Technical Field

The present invention relates to a thermoelectric conversion material of β-iron disilicides and a thermoelectric conversion element using the material.

Background Art

Thermoelectric effects, which are reversible phenomena between thermal energy and electric energy, are mainly classified into Seebeck effect, Peltier effect, and Thomson effect. The Seebeck effect is a phenomenon that when heterogeneous materials are bonded and one of the bonded materials is cooled, thermoelectromotive force is generated depending on temperature difference between the two bonded materials. The Peltier effect is a phenomenon that when heterogeneous materials are bonded and electric current is flown into the bonded materials, one of the bonded materials absorbs heat while the other generates heat. The Thomson effect is a phenomenon that when one end of a homogeneous material is heated and the other end is cooled, and DC current is flown along the temperature gradient, heat absorption or heat emission occurs within the material according to the current direction.

Thermal-to-electric direct energy conversion apparatus using the thermoelectric effects has features of having no moving parts causing vibration, noise, or abrasion, simple structure and high reliability, and long life and good maintainability. The apparatus is used for producing DC current directly from heat of combustion of various types of fossil fuels, or for temperature control without a refrigerant. The apparatus is used in RTG (Radioactive Thermoelectric Generator) mounted on the space probe satellite, thermoelectric generator by waste heat from an incinerator, or clock that operates by generating electricity based on temperature difference between body temperature and atmospheric temperature.

Furthermore, the thermal-to-electric direct energy conversion apparatus using the thermoelectric effects has features of being switchable between a heat absorption mode and a heat generation mode optionally in response to a current direction, besides being capable of an accurate temperature control. The apparatus is used for a refrigerator that may be used as not only a refrigerator but also a heating cabinet by turning a switch, and an accurate temperature adjustor used in a semiconductor factory.

Among these technologies using the thermoelectric effects, particularly, according to a technique that generates electricity directly from the thermal energy using the Seebeck effect, the thermal energy can be effectively used. Particular in recent years, it is expected that the technique is practically used for the reduction of carbon dioxide emission and recovery and reuse of waste heat from a factory. Although various materials are known as the thermoelectric conversion materials, a material of β-iron disilicides (hereinafter, shown as $\beta$-FeSi$_2$) is noted as the material useful in a temperature region from about 300°C to 800°C since the material has an excellent oxidation-resistance and raw materials of the material are comparatively low in cost. However, the material of $\beta$-FeSi$_2$ has a low thermoelectric conversion efficiency and thus the material is practically used only for the thermoelectric radio by waste heat from a candle at the present situation.

The thermoelectric conversion material of $\beta$-FeSi$_2$ is produced in the following manner. A predetermined amount of Fe and Si are doped with dopant that determines the conduction type such as Mn or Co (hereinafter, referred to as "dopant"), then melted and solidified. The resultant metallic phase (eutectic alloy of $\alpha$-phase with $\varepsilon$-phase) is subjected to a long time heat treatment, thereby transformed into $\beta$-phase that is a semiconductor phase. In the $\beta$-phase transformation, it is known that among Group XI elements or Group X elements in the periodic table, some elements such as Cu have an accelerating effect on the phase transformation when they are doped. For example, JP-A-7-211944 discloses Cu or Al as the phase transformation accelerating material. JP-A-8-139368 discloses a method in which a resin binder such as polyvinylalcohol having Cu uniformly dispersed therein is added to the metallic phase, and then molded, sintered, and subjected to heat treatment. The Cu doping accelerates the $\beta$-phase transformation rate 50 times or more, showing a large effect of Cu as the phase transformation accelerating material.

However, these phase transformation accelerating materials have no effect on improvement of the thermoelectric conversion efficiency of the material of $\beta$-FeSi$_2$. The reason for this is that the accelerating material such as Cu is not dissolved in the $\beta$-FeSi$_2$ crystal and exists as metal Cu at grain boundary of the $\beta$-phase crystal, therefore the material has no effect on the semiconductor properties of the $\beta$-FeSi$_2$ as disclosed in JP-A-7-211944.

JP-A-6-244465 describes improvement of the thermoelectric properties by doping Cu or Au compounds. However, it is considered that the reason for the improvement is because density of the material becomes high by increasing sintering temperature of the material, and stress is relieved by the accelerating material existing at the grain boundary.

JP-A-7-45869 discloses the thermoelectric conversion material characterized in that Ge is added in a composition of FeSi$_{2\pm z}$ (-0.1<z<0.1). In the description, the Ge doping decreases resistivity and increases power factor (W/m/K). However, Ge is a conductive carrier supply in the thermoelectric conversion material. Heat conduction in a solid has a lattice component and a carrier component. When the carrier component is increased, heat conductivity is increased and figure of merit is decreased. Here, the figure of merit is a ratio of power factor to heat conductivity. The power factor is a ratio of the square of Seebeck coefficient to resistivity. The carrier is a general term of conduction electrons and holes. Moreover, there is no description in the gazette on accelerating the β-phase transformation. Although the gazette describes a heat treatment for crystallization that is performed at 800°C for 1 hr as an example, it is only that crystallization is achieved in a short time because the material is a thin film material 1 μm in thickness, and a phase transformation accelerating effect of Ge is not exemplified.

As it is clear from the above, there has been no disclosure on improvement of the thermoelectric conversion efficiency in addition to acceleration of the β-phase transformation.

Disclosure of the Invention

The invention aims to provide a thermoelectric conversion material of β-FeSi$_2$ showing a high thermoelectric conversion efficiency by decreasing heat conductivity without changing Seebeck coefficient and resistivity, together with reducing the β-phase transformation time to just the industrially useful level, and a thermoelectric conversion element using the material.

The inventors found that when at least one selected from at least Sn and Pb is doped to the thermoelectric conversion material, the β-phase transformation is significantly accelerated. Furthermore, surprisingly, the inventors found that the thermoelectric conversion material of β-FeSi$_2$ doped with Sn or Pb has a significantly reduced heat conductivity without changing Seebeck coefficient and resistivity, as a result the thermoelectric conversion efficiency is significantly improved, consequently the inventors accomplished the invention.

That is, the invention provides a thermoelectric conversion material of β-FeSi$_2$ containing the dopant and at least one selected from at least Sn and Pb.

Preferably, the invention is a thermoelectric conversion material of β-FeSi$_2$ having an element composition expressed in the following formula (1) and a Sn doping ratio of 0.03 to 10 atomic percent, the ratio being expressed in $\{yz/(1+z)\}\times 100$:

$$Fe_{1-x}A_x(Si_{1-y}Sn_y)_z \hfill (1)$$

where A is the dopant, x is 0.01 to 0.25, and z is 1.5 to 2.5.

Preferably, the invention is a thermoelectric conversion material of β-FeSi$_2$ having an element composition expressed in the following formula (2) and a Pb doping ratio of 0.03 to 5 atomic percent, the ratio being expressed in $\{yz/(1+z)\}\times 100$:

$$Fe_{1-x}A_x (Si_{1-y}Pb_y)_z, \hfill (2)$$

where A is the dopant, x is 0.01 to 0.25, and z is 1.5 to 2.5.

More preferably, the dopant A is at least one selected from a group comprising Mn, Al, and Cr or at least one selected from a group comprising Co and Ni.

Moreover, the invention provides a thermoelectric conversion element of β-FeSi$_2$ comprising the thermoelectric conversion material of β-FeSi$_2$.

Best Mode for Carrying Out the Invention

Hereinafter, the thermoelectric conversion material of β-FeSi$_2$ of the invention (hereinafter, referred to as "thermoelectric conversion material of the invention") and the thermoelectric conversion element using the material are described in detail.

The thermoelectric conversion material of the invention contains the dopant and at least one selected from at least Sn and Pb, and has an element composition expressed in the following formula (3):

$$Fe_{1-x}A_x (Si_{1-y}M_y)_z, \hfill (3)$$

where A is the dopant, specifically, the dopant is Mn, Al, or Cr in case of a p-type thermoelectric conversion material, and Co or Ni in case of an n-type thermoelectric conversion material. Although the thermoelectric conversion material of the invention may contain only a single element as the dopant, it may also contain plural types of elements such as Mn and A1 if their conduction types are the same.

While depending on the dopant type, x is typically in a range from 0.01 to 0.25, and preferably 0.03 to 0.1. Even when A comprises plural elements, the preferable range of x is same as the above.

The value of Z is preferably 1. 5 to 2.5, andmore preferably 1.8 to 2.2. When the value is less than 1.5, formation of ε-FeSi increases, and the β-phase transformation accelerating effect is reduced and the effect of reducing the thermal conductivity is inadequate, therefore it is not preferable. When the value of z is more than 2.5, while the β-phase transformation accelerating effect is high, resistivity is increased by residual Si, therefore it is not preferable.

The M shown in the formula (3) expressing an element composition of each component of the thermoelectric conversion material of the invention is at least one element selected from at least Sn and Pb, and may contain either one of Sn or Pb only, or may contain both of the elements together. The thermoelectric conversion material with M has a significantly fast β-phase transformation rate compared with a material without M. In addition, in the elements, the Seebeck coefficient and resistivity does not changed and the heat conductivity is significantly decreased, thereby the thermoelectric conversion efficiency becomes high. Particularly, since large number of doping elements is not necessarily advantageous in an industrial viewpoint, it is preferable that Sn or Pb is doped singly as M. Moreover, considering toxicity of the Pb compounds, it is particularly preferable that Sn is doped singly.

When the thermoelectric conversion material of the invention contains Sn as M, it is preferable that the doping ratio of Sn is in a range from 0.03 to 10 atomic percent, and it is particularly preferable that the ratio is 0.3 to 3 atomic percent.

In the invention, the doping ratio of Sn or Pb is a value defined by the following formula (4) based on the formula (1), (2), or (3):

$$\text{doping ratio} = [yz/(1+z)] \times 100 \text{ (atomic percent)} \tag{4}$$

When the doping ratio of Sn is less than 0.03 atomic percent, both of the β-phase transformation accelerating effect and the effect of reducing the heat conductivity of the element are inadequate, therefore effects of the invention are not obtained. When the doping ratio of Sn is more than 10 atomic percent, while the phase transformation accelerating effect is sufficiently high, the amount of Sn that is indissoluble in $FeSi_2$ is increased, and the effect of reducing the heat conductivity is not shown and the oxidation-resistant of the element is reduced, therefore it is not preferable.

When the thermoelectric conversion material of the invention is doped with Pb as M, it is preferable that the doping ratio of Pb is in a range from 0.03 to 5 atomic percent, and it is particularly preferable that the ratio is 0.2 to 2 atomic percent.

When the doping ratio of Pb is less than 0.03 atomic percent, both of the β-phase transformation accelerating effect and effect of reducing the heat conductivity of the element are inadequate, therefore the effects of the invention is not obtained. When the doping ratio of Pb is more than 5 atomic percent, while the phase transformation accelerating effect is sufficiently high, the amount of Pb that is indissoluble in $FeSi_2$ is increased, thereby the effect of reducing the heat conductivity is not shown and the oxidation-resistant of the element is reduced, therefore it is not preferable. Moreover, when the doping ratio of Pb is more than 5 atomic percent, toxic Pb compounds may be possibly precipitated, therefore it is not preferable.

In a preferable aspect of the invention, Sn or Pb is perfectly dissolved in $FeSi_2$ to the region of a comparatively low doping ratio, however at a comparatively high doping ratio, Sn or Pb is sometimes not dissolved perfectly in $FeSi_2$ even if it is within a scope of the preferable aspect of the invention. However, since the indissoluble Sn or Pb is not much and may exist at the grain boundary of $FeSi_2$ in a uniformly dispersed manner, the effects of the invention are maintained. The doping ratio at which Sn or Pb is perfectly indissoluble is also changed depending on the doping ratio x of the dopant A in the general formula (1) , therefore it can not be generally determined. It is preferable that the doping ratio in the case that Sn and Pb are contained together is in a range from 0.03 to 5 atomic percent, and it is particularly preferable that the ratio is 0.2 to 3 atomic percent.

The thermoelectric conversion material of the invention can be produced according to a known method, which is not limited to a particular one. Specific production methods are shown in the following (a) to (d).

(a) For example, JP-A-8-139368 describes the following method. Raw materials are subjected to melting by a high frequency and quenching, thereby ingot comprising eutectic alloy of ε-phase with α-phase is formed. The ingot is pulverized, and then the pulverized ingot is added with a binder and granulated. The granulated material is molded into a desired shape by a cold press and degreased. Then, the degreased material is sintered into a sintered compact having a desired shape. The sintered compact is additionally subj ected to heat treatment, thereby the eutectic alloy forming the sintered compact is made to perform the β-phase transformation.

(b) For example, JP-A-7-211944 describes the following method. The raw materials are subjected to the melting by a high frequency, thereby a molten alloy is formed, and the molten alloy is subjected to cooling into a container with equipment for a high pressure gas spray using an inert gas (gas atomizing method) or equipment for water spray using high pressure water (water atomizing method), thereby fine eutectic alloy powder is obtained. The powder is added with a binder and granulated. The granulated powder is molded into a desired shape by the cold press and degreased. The degreased material is sintered into a sintered compact having a desired shape. The sintered compact is additionally subjected to the heat treatment, thereby the eutectic alloy forming the sintered compact is made to perform the $\beta$-phase transformation.

(c) The eutectic alloy powder is directly obtained using the mechanical alloying method in which the raw material powder is mixed and dispersed, and then made to be in an atomic level mixture condition by mechanically repeating pulverization and pressure bonding. The powder is added with a binder and granulated, then molded into a desired shape by the cold press and degreased, and then sintered into a sintered compact having a desired shape. The sintered compact is additionally subjected to the heat treatment, thereby the eutectic alloy forming the sintered compact is made to perform the $\beta$-phase transformation.

(d) Raw materials are dissolved in a molten metal with a low melting point such as Ga or In, and temperature difference is set in the solution, thereby crystal of the thermoelectric conversion material powder of the invention is obtained in a low temperature region (for example, a solution growth method described in Haruhiko Udono; "Solution Growth of Semiconductor Silicides Bulk Crystal", Zairyokagaku, 37 (1), pp34-38 (1999), (in Japanese)). After that, various methods can be used, including a method in which the $\beta$-phase transformation of iron silicides is performed by a series of processes comprising the press molding, degreasing, sintering, and heat treatment as the above (a) to (c).

Mixers for use in the mechanical alloying include apparatus for mixing and dispersing by mechanical shock such as an inverting ball mill, a vibrating ball mill, an epicyclic ball mill, and an attritor mill.

The sintering method includes a method of sintering by heating in a vacuum, in an atmosphere of a reducing gas such as hydrogen, or in an inert gas atmosphere. Alternatively, the spark plasma sintering (PAS) method is given, in which first pulsed current is flown in the powder to generate discharge therein, and then DC current is applied for heating and sintering. The PAS method has an advantage that a fine sintered compact can be obtained in a short time even at a comparatively low temperature.

The heat treatment may be carried out in air, an inert gas atmosphere, or an atmosphere of a reducing gas such as hydrogen using common apparatus such as an electric furnace, the apparatus being not limited to particular one. At that time, in the heat treatment of the thermoelectric conversion material of the invention, the $\beta$-phase transformation of iron silicides is accelerated by doping at least one selected from at least Sn and Pb, and the $\beta$-phase transformation of iron silicides can be performed in a short time of about 1/25 to 1/50 of the traditional one.

Furthermore, the thermoelectric conversion material of the invention has no limit on a relative density. For example, the material may be a porous structure as described in Koji Hayashi; "Sintered Porous Material for Thermoelectric Conversion Element; -Thermoelectric Conversion Element For Gas-Fired Porous Structure Thermoelectric Power Generator-" Materia, 35(9), pp965-968(1996) (in Japanese).

A raw material for the thermoelectric conversion material of the invention, that is, Fe, Si, dopant, Sn, or Pb has no limit on its purity. Each of an industrial material of low purity (about 98 to 99%) and a material of high purity (99.99% or more) can be used. For example, a material described in Isao Nishida; "Method for Producing Intermetallic Compound Semiconductor $FeSi_2$ and Thermoelectric Characteristics Thereof" Tetsutohagane, 81(10), N454-N460 (1995), (in Japanese), or electrolytic iron, or polycrystalline silicon for semiconductor can be used. Any form including ingot or crudely pulverized powder thereof, or powder can be properly used as the form of the material, depending upon the production method.

Moreover, the invention provides a thermoelectric conversion element of $\beta$-$FeSi_2$ comprising the thermoelectric conversion material of the invention. The form of the thermoelectric conversion element is not particularly limited. Any form such as U type element shown in Isao Nishida; "Method for Producing Intermetallic Compound Semiconductor $FeSi_2$ and Thermoelectric Characteristics Thereof" Tetsutohagane, 81 (10), N454-N460 (1995), (in Japanese) or $\pi$ type can be selected depending on purpose of usage or application.

Relations between the application and the element form are described more specifically below. When thermoelectric power generation is performed using waste heat generated from various industrial furnaces such as an incinerator or a baking furnace, typically, there is sufficient space for installation of the thermoelectric power generator and temperature of heat source is high, 1000°C or more, therefore the U type element that enables integral molding and integral sintering of a p-type material with a n-type material is preferably selected though the element has a large height compared with the $\pi$ type. On the other hand, when the thermoelectric power generation is performed using exhaust heat from car exhaust emission, the $\pi$ type element is preferably selected since the installation space or weight for the thermoelectric power generator is limited, and the temperature of the heat source is low compared with a use for furnace.

The element can be produced by molding it into a predetermined shape during sintering the thermoelectric conversion material, or can be performed by molding it into the predetermined shape after the sintering and heat treatment. It is possible that the eutectic alloy powder is mixed with a dispersing agent or solvent, thereby slurry is prepared, then a p-type sheet and an n-type sheet are molded using the doctor-blade method, then stacked and cut into a predetermined shape, and then sintered.

A module using the combination of the thermoelectric conversion module comprising the U type or π type element group produced from the thermoelectric conversion material of β-FeSi$_2$ of the invention with a thermoelectric conversion module comprising a thermoelectric conversion material for low temperature service such as material of Bi-Te, what is called, a cascade module may be also produced. In this case, since the thermoelectric conversion is additionally performed using low-temperature heat source exhausted from the element group of the invention, generation power per unit area is increased, which is particularly preferable for a use having a limit for the installation space such as a use for the automobile.

Example

Hereinafter, the invention is described in detail according to examples of the invention and comparative examples, however, the examples are not intended to limit the invention.

Industrial iron powder (purity of 99%) , industrial metal silicon (purity of 99.5%) , and high-purity metal reagents (Sn 99.99% in purity, Pb 99.9% in purity, Mn 99.99% in purity, and Co 99.9% in purity) were used as raw materials. The iron powder was molded into a disc shape 20 mm in diameter and 3 mm in thickness and then used.

Respective materials were weighed such that the compositions shown in table 1 are given, and then melted at a temperature of 1873 K or more in an argon atmosphere using a high frequency melting furnace. The resultant ingot was pulverized and powder having a grain size of 53 μm or less was sampled. Results of element analysis of the powder show that mixing compositions in weighing the raw materials, shown in table 1, were well corresponded with the analytical values.

The sampled powder was granulated into a granular form having a grain size of about 1 mm using an ethanol solution of 1, 3-butandiol as a binder, then molded into a predetermined shape (25 mm by 10 mm by 4mm thick and 11.5 mm in diameter by 8 mm in thickness) by the cold press at a pressure of $1.16 \times 10^2$ MPa. The resultant green compact was subjected to vacuum sintering (pressure of 0.5 Pa or lower) at a temperature of 1448 K or more, thereby formed into a sintered material having a relative density of 70% or more, and then made to perform the β-phase transformation through heat treatment at 1123 K for a predetermined time.

The specimens after the β-phase transformation of iron silicides were machined into a test piece of 3 mm by 3 mm by 16 mm for measuring Seebeck coefficient and resistance, a test piece of 10 mm in diameter by 1 mm in thickness for measuring heat conductivity, and a test piece of 8 mm by 3 mm by 10 mm for measuring X-ray diffraction respectively. The Seebeck coefficient and resistivity were measured using the thermoelectric characteristic evaluation apparatus made by ULVAC-RIKO Inc. , and the heat conductivity was measured using the laser-flash/thermophysical-properties-measuring-apparatus made by ULVAC-RIKO Inc.

Table 1 shows compositions of the thermoelectric conversion materials of β-FeSi$_2$ prepared as the examples of the invention and comparative examples together with measurements of properties (Seebeck coefficient, resistivity, and heat conductivity) at 773 K and time for β-transformation of iron silicides of the thermoelectric conversion elements using the materials. Here, the relative density is a ratio of the measured density of each of the prepared test pieces to the theoretical density of β-FeSi$_2$ (4.95). The time for β-transformation of iron silicides is the heat treatment time required for achieving the β-phase composition of 90% or more. The β-phase transformation was confirmed using the X-ray diffraction method, and the β-phase composition was calculated from an X-ray diffraction intensity ratio of α-phase (Miller index hkl is 102) , ε-phase (Miller index hkl is 210) , and β-phase (Miller index hkl is 202). That is, the β-phase composition was calculated on an assumption that when the X-ray diffraction intensities of the α-phase, ε-phase, and β-phase were $I_\alpha$, $I_\varepsilon$, and $I_\beta$ respectively, a diffraction intensity ratio $I_\beta / (I_\alpha + I_\varepsilon + I_\beta)$ was equal to the composition of β-phase. The measured density was calculated from measured values of the dimension and mass of the prepared test piece.

As it is clear from table 1, the heat conductivity of the thermoelectric conversion element of β-FeSi$_2$ of the invention is less than half of the heat conductivity of each comparative example without doping Sn or Pb (Fe$_{0.92}$Mn$_{0.08}$Si$_2$ or Fe$_{0.97}$Co$_{0.03}$Si$_2$). Furthermore, the time for β-transformation of iron silicides of the element of the invention is significantly reduced as small as 1/25 to 1/50 of the time for β-transformation of iron silicides of the comparative example, which shows the significant effect of the invention on the reduction of the heat conductivity and reduction of the β-phase transformation time. The Seebeck coefficient and resistivity of the element of the invention and the Seebeck coefficient and resistivity of the comparative example are in the range of the experimental errors and almost equal to each other, therefore it is obvious that the figure of merit of the thermoelectric conversion element of the invention is improved two times or more, showing significant increase of the thermoelectric conversion efficiency.

Industrial Applicapability

The thermoelectric conversion material of the invention has a significantly accelerated β-phase transformation speed, thereforeheattreatmenttime of thematerial is reduced, thereby reduction in production time and cost can be achieved in industrial production, and therefore the material is significantly advantageous for improvement in productivity. Moreover, the thermoelectric conversion material of the invention has low heat conductivity, therefore the thermoelectric conversion efficiency is significantly improved, and a thermoelectric conversion element of $\beta$-FeSi$_2$ having an excellent thermoelectric conversion performance can be obtained, therefore the material is usable for various thermoelectric conversion apparatus. The thermoelectric conversion material of the invention is also useful as a raw material for various elements using not only the Seebeck effect, but also the Peltier effect and Thomson effect.
Moreover, the thermoelectric conversion element of the invention has an excellent thermoelectric conversion performance, therefore the element is applied to apparatus that performs direct generation from thermal energy, thereby it is expectable that the element is practically used for efficient use of thermal energy, particularly in recent years, the reduction of carbon dioxide emissions or the recovery and reuse of the waste heat from a factory or an automobile.

Table 1

| | Composition (doping ratio of Sn or Pb %, value of z) | Relative density (%) | Seebeck coefficient ($\mu$V/K) | Resistivity (m$\Omega$m) | Heat conductivity (W/mK) | Time for $\beta$-transformation of iron silicides (h) | Figure of merit* (1/K) |
|---|---|---|---|---|---|---|---|
| Example | $Fe_{0.92}Mn_{0.08}Si_{1.995}Sn_{0.005}$ (0.17, Z=2) | 95 | 305 | 0.16 | 1.2 | 4.0 | $4.85 \times 10^{-4}$ |
| Example | $Fe_{0.92}Mn_{0.08}Si_{1.98}Sn_{0.02}$ (0.67, Z=2) | 93 | 313 | 0.17 | 1.1 | 3.5 | $5.24 \times 10^{-4}$ |
| Example | $Fe_{0.84}Mn_{0.08}Si_{1.75}Sn_{0.25}$ (8.3, Z=2) | 88 | 306 | 0.18 | 1.0 | 3.0 | $5.20 \times 10^{-4}$ |
| Example | $Fe_{0.97}Co_{0.03}Si_{1.97}Sn_{0.03}$ (1.0, Z=2) | 97 | 295 | 0.15 | 1.0 | 3.5 | $5.80 \times 10^{-4}$ |
| Example | $Fe_{0.96}Co_{0.04}Si_{1.99}Sn_{0.002}$ (0.07, Z=1.992) | 85 | 308 | 0.17 | 1.1 | 5.5 | $5.07 \times 10^{-4}$ |
| Example | $Fe_{0.97}Co_{0.03}Si_{1.85}Sn_{0.15}$ (5.0, Z=2) | 93 | 290 | 0.17 | 0.9 | 2.5 | $5.50 \times 10^{-4}$ |
| Example | $Fe_{0.97}Co_{0.03}Si_{1.773}Sn_{0.027}$ (0.96, Z=1.8) | 95 | 290 | 0.13 | 1.2 | 4.0 | $5.39 \times 10^{-4}$ |
| Example | $Fe_{0.97}Co_{0.03}Si_{2.167}Sn_{0.033}$ (1.03, Z=2.2) | 95 | 290 | 0.16 | 1.0 | 2.0 | $5.26 \times 10^{-4}$ |
| Example | $Fe_{0.97}Co_{0.03}Si_{1.97}Pb_{0.03}$ (1.0, Z=2) | 95 | 302 | 0.18 | 1.0 | 2.5 | $5.07 \times 10^{-4}$ |
| Example | $Fe_{0.97}Co_{0.03}Si_{1.87}Pb_{0.1}$ (3.4, Z=1.97) | 86 | 287 | 0.18 | 0.9 | 2.0 | $5.08 \times 10^{-4}$ |
| Comparative example | $Fe_{0.92}Mn_{0.08}Si_2$ (0, z=2) | 95 | 310 | 0.15 | 2.6 | 150 | $2.46 \times 10^{-4}$ |
| Comparative example | $Fe_{0.7}Co_{0.03}Si_2$ (0, z=2) | 96 | 300 | 0.14 | 2.5 | 136 | $2.57 \times 10^{-4}$ |

Note; figure of merit = (Seebeck coefficient)$^2$ / (resistivity) / (heat conductivity)

**Claims**

1.  A thermoelectric conversion material of β-iron disilicides containing dopant and at least one selected from at least Sn and Pb.

2.  A thermoelectric conversion material of β-iron disilicides having an element composition expressed in the following formula (1) and Sn dopant ratio of 0.03 to 10 atomic percent, the ratio being expressed in $\{yz/(1+z)\}\times100$:

$$Fe_{1-x}A_x (Si_{1-y}Sn_y)_z, \qquad (1)$$

   where A is the dopant, x is 0.01 to 0.25, and z is 1.5 to 2.5.

3.  A thermoelectric conversion material of β-iron disilicides having an element composition expressed in the following formula (2) and Pb dopant ratio of 0.03 to 5 atomic percent, the ratio being expressed in $\{yz/(1+z)\}\times100$:

$$Fe_{1-x}A_x (Si_{1-y}Pb_y)_z, \qquad (2)$$

   where A is the dopant, x is 0.01 to 0.25, and z is 1.5 to 2.5.

4.  The thermoelectric conversion material of β-iron disilicides according to any one of claims 1 to 3, wherein the dopant is at least one selected from a group comprising Mn, Al, and Cr or at least one selected from a group comprising Co and Ni.

5.  A thermoelectric conversion element of β-iron disilicides comprising the thermoelectric conversion material of β-iron disilicides according to any one of claims 1 to 4.

## INTERNATIONAL SEARCH REPORT

| | International application No. |
| --- | --- |
| | PCT/JP03/07395 |

**A. CLASSIFICATION OF SUBJECT MATTER**
Int.Cl$^7$ H01L35/14

According to International Patent Classification (IPC) or to both national classification and IPC

**B. FIELDS SEARCHED**

Minimum documentation searched (classification system followed by classification symbols)
Int.Cl$^7$ H01L35/14, C01B33/06

Documentation searched other than minimum documentation to the extent that such documents are included in the fields searched

| | | | |
| --- | --- | --- | --- |
| Jitsuyo Shinan Koho | 1922–1996 | Toroku Jitsuyo Shinan Koho | 1994–2003 |
| Kokai Jitsuyo Shinan Koho | 1971–2003 | Jitsuyo Shinan Toroku Koho | 1996–2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2000-247624 A (Japan Science and Technology Corp.), 12 September, 2000 (12.09.00), Full text; Figs. 1 to 2 (Family: none) | 1-5 |
| A | JP 10-012933 A (Sumitomo Special Metals Co., Ltd.), 16 January, 1998 (16.01.98), Full text; Fig. 1 (Family: none) | 1-5 |
| A | JP 6-107407 A (Nissan Motor Co., Ltd.), 19 April, 1994 (19.04.94), Full text; Figs. 1 to 7 (Family: none) | 1-5 |

| ☒ Further documents are listed in the continuation of Box C. | ☐ See patent family annex. |
| --- | --- |

| \* Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 28 August, 2003 (28.08.03) | 09 September, 2003 (09.09.03) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

**INTERNATIONAL SEARCH REPORT**

| International application No. |
| --- |
| PCT/JP03/07395 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 6-097512 A  (Sumitomo Special Metals Co., Ltd.), 08 April, 1994 (08.04.94), Full text; Figs. 1 to 9 (Family: none) | 1-5 |

Form PCT/ISA/210 (continuation of second sheet) (July 1998)